# EUROPEAN PATENT SPECIFICATION

(11) **EP 4 348 337 B1**
(45) Date of publication and mention of the grant of the patent: **13.05.2026**
(21) Application number: 22726780.4
(22) Date of filing: 23.05.2022
(51) Int. Cl.: G02B 27/01, H01S 5/065

(54) **AN OPTICAL WAVEGUIDE ARRANGEMENT FOR REDUCING INTERFERENCE PATTERNS**
OPTISCHE WELLENLEITERANORDNUNG ZUR REDUZIERUNG VON INTERFERENZMUSTERN
AGENCEMENT DE GUIDE D'ONDES OPTIQUE POUR RÉDUIRE DES MOTIFS D'INTERFÉRENCE

(30) Priority: 25.05.2021 FI 20215616
(43) Date of publication of application: 10.04.2024
(73) Proprietor: Dispelix Oy, 02130 Espoo (FI)
(72) Inventor: BLOMSTEDT, Kasimir, 02130 Espoo (FI)
(74) Representative: Ipsilon Belgium
(86) International application number: PCT/FI2022/050348
(87) International publication number: WO 2022/248767

(56) References cited:
- US-A1- 2019 011 722
- US-A1- 2019 179 078
- US-A1- 2020 373 734

## Description

### FIELD

Embodiments of the present invention relate in general to an optical waveguide arrangement and more specifically to an optical waveguide arrangement for reducing interference patterns.

### BACKGROUND

Head-Mounted Displays, HMDs, and Head-Up Displays, HUDs, can be implemented using optical waveguide technology, as for example described in documents US 2020/373734 A1, US 2019/179078 A1 and US 2019/011722 A1. Optical waveguides, such as diffractive waveguides, may be used with light sources having narrow spectral bandwidth, e.g., lasers and optically filtered Light-Emitting Diodes, LEDs. Such waveguides typically suffer from interference patterns visible in the virtual image though. These interference patterns may be cylindrically symmetric for example, such as Newton rings. The interference patterns are an undesired effect since those weaken the quality of the image produced by the display. There is therefore a need to provide an optical waveguide arrangement for reducing interference patterns.

### SUMMARY OF THE INVENTION

According to some aspects, there is provided the subject-matter of the independent claims. Some embodiments are defined in the dependent claims.

According to a first aspect of the present invention, there is provided an optical waveguide arrangement comprising a light source arranged to transmit a light signal to at least one optical waveguide of the optical waveguide arrangement, the at least one optical waveguide, wherein the at least one optical waveguide is arranged to receive the light signal from the light source and to convey the light signal to a human eye, to generate a waveguide-based display and at least one processor configured to control the light source, wherein the at least one processor is configured to cause shaping of a spectrum of the light signal during a period of time, said period of time corresponding to a persistence time of vision of the human eye; and wherein the distinct spectral characteristic of the light signal is swept continuously during the period of time.

According to a second aspect of the present invention, there is provided a head-mounted display or a head-up display comprising the optical waveguide arrangement of the first aspect.

According to a third aspect of the present invention, there is provided a method comprising transmitting by a light source a light signal to at least one optical waveguide of the optical waveguide arrangement, receiving by the at least one optical waveguide the light signal from the light source and conveying the light signal to a human eye, to generate a waveguide-based display and controlling the light source by at least one processor to cause shaping of a spectrum of the light signal during a period of time, said period of time corresponding to a persistence time of vision of the human eye; and wherein sweeping the distinct spectral characteristic of the light signal happens continuously during the period of time.

According to a fourth aspect of the present invention, there is provided a non-transitory computer readable medium having stored thereon a set of computer readable instructions that, when executed by at least one processor, cause an apparatus to at least perform the method.

According to a fifth aspect of the present invention, there is provided a computer program comprising instructions which, when the program is executed by an apparatus, cause the apparatus to perform the method.

### BRIEF DESCRIPTION OF THE DRAWINGS

FIGURE 1 illustrates an example system in accordance with at least some embodiments of the present invention;
FIGURE 2 illustrates an exemplary operation of a waveguide in accordance with at least some embodiments of the present invention;
FIGURE 3 illustrates an example apparatus capable of supporting at least some embodiments of the present invention;
FIGURE 4 illustrates a first example of shaping of a spectrum of a light signal in accordance with at least some embodiments of the present invention;
FIGURE 5 illustrates a second example of shaping of a spectrum in accordance with at least some embodiments of the present invention; and
FIGURE 6 is a flow graph of a method in accordance with at least some embodiments of the present invention.

### EMBODIMENTS

Embodiments of the present invention relate to an optical waveguide arrangement for reducing interference patterns, such as Newton rings. In accordance with at least some embodiments of the present invention, interference patterns may be reduced by sweeping a distinct spectral characteristic, such as a distinct spectral peak, of a light signal during a period of time, wherein said period of time corresponds to the persistence time of vision of the human eye, which may also be referred to as an averaging/integration time of the human eye. The human eye may be considered as a detector and thus, the persistence time of vision of the human eye equals the coherence time of the corresponding detector.

It should be noted that in embodiments of the present invention coherence time, coherence length and other characterizations of coherence do not refer to the coherence characteristics of the light field source alone, as is typical, but to the joint coherence characteristics of source and detector. Specifically, since the time scale of persistence of vision in the human eye is typically tens of milliseconds low frequency changes/modulations (compared to the central frequency of a laser) of the spectral characteristics of the light source influence the visibility of interference fringes (to the human eye), and it is this effect that is utilized herein. That is, the visibility of interference effects to the human eye are dependent on the light source spectral distribution as averaged over the persistence of vision time, and can hence be influenced by modulating said spectrum within this time frame. Shaping of the spectrum may be done for example by sweeping the peak wavelength of a laser source across a wide enough wavelength band, but more complicated light sources and more complicated changes to the spectrum can also be used. Shaping of the spectrum may comprise changing amplitude and/or wavelength.

The peak wavelength may be swept for example within a range of few nanometres, such as within a range of 2 nanometres. That is to say, the peak wavelength may be moved across the range, from one end of the range to the other end of the range, in a continuous motion or as a series of smaller discrete shifts. In general, the spectral characteristic of the light signal may be changed multiple times, i.e., more than once, during a period of time. In some embodiments, said period of time may be 20 milliseconds, which corresponds to the averaging/integration time of a typical human eye. The changes may thus be repeated, for example 50 times in a second. In some example embodiments, said period of time is 5 - 200 milliseconds.

According to at least some embodiments of the present invention, optical waveguide-based displays may be used for Head-Mounted Displays, HMDs, and Head-Up Displays, HUDs. In general, optical waveguides are capable of conveying optical frequency light. Optical, or visible, frequencies may refer to light signals within about 400 to 700 nanometres in wavelength. Optical waveguides may be suitable for augmented reality or virtual reality type applications for example. In augmented reality, a user sees a view of the real world and superimposed thereon supplementary indications. In virtual reality, the user is deprived of his view into the real world and provided instead a view into a software-defined scene.

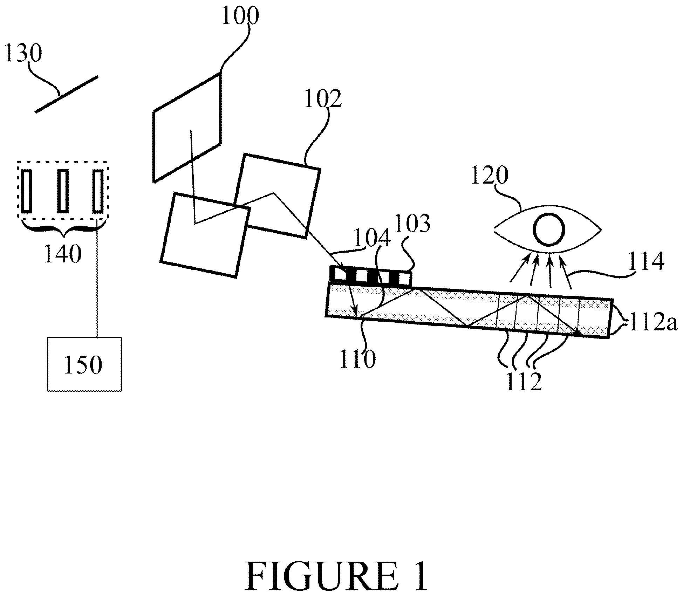

FIGURE 1 illustrates an example system in accordance with at least some embodiments of the present invention. The system may comprise a set of light sources 140. Light sources 140 may comprise laser or Light-Emitting Diode, LED, light sources, for example, wherein laser sources have the advantage that they are more strictly monochromatic than LEDs. Light sources 140 together with other optical components, for example a MEMS mirror 130, form an optical system which may be configured to generate a light field in angular space. The image is encoded in the light field. The light field is schematically illustrated in FIGURE 1 as field 100. In some embodiments, a physical primary display may display an image of light field 100, while in other embodiments the system may comprise no physical primary display and the image is merely encoded in the light field which is distributed in angular space. Light signal 104 from light field 100 may be conveyed directly, or by, using optical guides 102 comprising, for example, mirrors and/or lenses, to an optical waveguide 110, to generate a waveguide-based display. The optical guides 102 are optional in the sense that depending on the specifics of a particular embodiment, they may be absent. In other words, optical guides 102 are not present in all embodiments.

Light signal 104 from a light source 140 may be directed to an in-coupling structure 103, such as a partially reflecting mirror, surface relief grating or other diffractive structures. The in-coupling structure 103 may comprise one or more in-coupling gratings and/or prisms for example. The in-coupling structure 103 may be arranged to guide the light ray 104 into the optical waveguide 110. That is to say, the in-coupling structure 103 may diffractively couple an image into the optical waveguide 110. As shown in FIGURE 1, in some embodiments, the in-coupling structure 103 may be on a surface, or close to the surface, of the optical waveguide 110 for example. However, in some embodiments the optical waveguide 110 may comprise the in-coupling structure 103.

In some embodiments, the in-coupling structure 103 may be absent though and in such cases it is possible to get the light signal 104 into the optical waveguide 110 by illuminating a side surface of the optical waveguide 110 directly.

In the waveguide 110, light signal 104 may advance by being reflected repeatedly inside the waveguide, interacting with elements 112a until it interacts with elements 112 which cause it to be deflected from waveguide 110 to air, towards eye 120 as image producing light signals 114. Elements 112a and 112 may be located on either side or both sides of the optical waveguide 110, wherein a side of the optical waveguide 110 refers to the side which is towards the eye 120 or to the "outside world" side. Elements 112a and 112 may comprise partially reflecting mirrors, surface relief gratings or other diffractive structures, for example. Elements 112a may be arranged, for example, to spread light field 100 inside waveguide 110 such that the image of the waveguide display is correctly generated. As light from different angular aspects of light field 110 will interact with elements 112, light signals 114 will produce the image encoded in light field 100 on the retina of eye 120. Light may interact with elements 112 in distinct sequences, wherein all elements 112 are not necessarily used all the time. Not all of the light needs to necessarily hit all elements 112.

Elements 112 then cause the light signal 104 to leave waveguide 110 at an exit location or at multiple exit locations. As a consequence, the user will perceive the image encoded in light field 100 in front of his eyes 120. As waveguide 110 may be, at least in part, transparent, the user may also advantageously see his real-life surroundings through waveguide 110 in case the waveguide-based display is head-mounted, for example. Light is released from waveguide 110 as a consequence of the action of the elements 112, i.e., elements 112 may be referred to as out-coupling elements.

A color image may be generated, for example by assuming the user's color vision perception corresponds to a standard eye. A term "color space" refers to the (two-dimensional) chromaticity diagram corresponding to the perceived colors resulting from the spectral response of an average human eye. The gamut of a device is the region of the color space, which is reproducible by that device. Specifically, here the gamut corresponds to the region in color space, which can be reproduced by the combination of light sources 140 and waveguides in the system for light fields that the observer perceives to originate from a focal plane. The Region of Interest, ROI, in turn, refers to a region of color space that is sufficient to reproduce what is perceived as a full color image, but may also correspond to a smaller or larger region of color space. As a specific point in the color space can be reached by different combinations of wavelengths, a specific ROI can be reached using different combinations of distinct spectral characteristics, such as peaks in visible spectrum.

A color image may be generated, for example by assuming the user's color vision perception corresponds to a standard eye and by reproducing (a part of) the corresponding color space. As is clear from the definition of the color space, the user perceives the same color as the result of several different light signal spectra. This provides degrees of freedom to how a waveguide 110 operates. In addition, different combinations of distinct spectral characteristics, such as wavelengths, may be used to generate the same color. How light is coupled out of the waveguide may be a function of the exit location. That is, a light ray corresponding to a specific position in the input image (specific propagation angle) may leave the waveguide at different angles depending on the exit location. In general, the user may perceive a same color from more than one spectrum of light signals 114. This yields degrees of freedom in manufacturing waveguide 110.

In a waveguide-based display, there may be present plural optical waveguides 110, i.e., a stack of optical waveguides 110 on top of each other. Plural optical waveguides 110 may for example convey light simulating different apparent depths in front of eye 120, as well as, optionally, the user's other eye which is not illustrated in FIGURE 1 for the sake of clarity of the illustration. Alternatively, or in addition, plural optical waveguides may be used to produce a larger field of view.

The light field 100 encoding the image may be generated using an optical system comprising, for example, a mirror 130 and laser light sources 140. Mirror 130 may comprise, for example, a Microelectromechanical System, MEMS, mirror which is configured to reflect light signals from light sources 140 as to generate the image encoding light field 100 in a controlled manner by, for example, scanning the angular space thereby generating the light field encoding the image. Mirror 130 may therefore be actuated to tilt to different angles so as to direct the light from light sources 140 to the appropriate parts of the light field 100 in angular space.

In some embodiments, the optical system may consist of other types of image generating devices, such as projectors, where the light sources may for example be LEDs and a primary display may be present in the form of a Liquid Crystal on Silicon, LCOS, device. The optical system maps the image from the primary display to angular space, thereby generating a light field for input to waveguide 110.

The example system illustrated in FIGURE 1 comprises three light sources 140 and at least one processor 150 configured to control light sources 140. This is an example to which the present disclosure is not limited, rather, there may be fewer than three, or more than three, light sources 140. The light sources 140 may be considered as monochromatic in the sense that they may produce either narrow spectral band of light with a single peak wavelength, as in lasers, or their spectral band may be wider, as with LEDs. Light sources with more complicated spectral distributions are also possible. In principle, the color space that humans can see may be generated by appropriately exciting the light receptors on the retina. Typically, this is achieved by mixing three wavelengths of light, for example at one wavelength in each in the red, green and blue parts of the visual spectrum. It may also be accomplished by mixing light from three light sources with more complex spectra.

To produce a color image encoded in the light field 100 in angular space, light sources 140 may, for example, be programmatically controlled. In instances where the mirror 130 is present, light sources 140 and the mirror 130 may be synchronized with each other such that light from light sources 140 illuminates specific angular regions of the angular space 100 in a controlled manner so as to produce therein a representation of a color image which reproduces a still or moving input image received from an external source, such as, for example, a virtual reality or augmented reality computer. The still or moving image received from the external source may comprise a digital image or a digital video feed, for example. The image encoded in light field 100 is thus configurable by provision of a suitably selected input image.

To produce a specific color at a given aspect in angular space of light field 100, this given aspect in the angular space may be illuminated by a set of three light sources 140 for example. This specific color is then reproduced by the light signals 114, as light from the given aspect in the angular space of light field 100 proceeds in waveguide 110 to an element 112 where it exists at angle corresponding to the given aspect in the angular space 100.

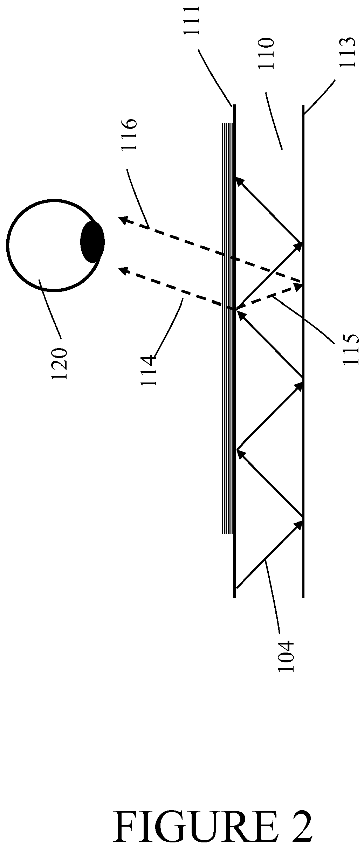

FIGURE 2 illustrates an exemplary operation of a waveguide in accordance with at least some embodiments of the present invention. As shown in FIGURE 2, light signal 140, such as a laser signal, may propagate via internal reflections within waveguide 110 and interact at interface 111 of waveguide 110, thereby creating two light signals 114 and 115. Interface 111 may be towards eye 120. First light signal 114 may further propagate towards eye 120 and second light signal 115 may propagate towards opposite interface 113 of waveguide 110. Opposite interface 113 may be towards the world. Second light signal 115 may then reflect partially from opposite interface 113, thereby forming reflected light signal 116. Even though only one reflected signal 116 is shown in FIGURE 2 for the sake of clarity, there may be more than one reflected signal 116. In practice there may be an infinite number of reflected signals, but the reflected signals are attenuated and hence typically only the first, and possibly the second, reflected signal is of importance.

Consequently, reflected light signal 116 may interfere with light signal 114 and cause visible interference patterns, if the coherence length of the system comprised by the light source and the detector (human eye) is larger than the optical path length difference of the light signals. The interference patterns, may for example occur in the form of Newton rings. So even though interference always occurs, the effects of the interference are usually not visible when the path length difference is larger than the coherence length of the system.

The strength of the interference patterns occurring in the example of FIGURE 2 may be reduced by temporally modulating the spectral distribution within the time frame of persistence of vision, for example by modulating the spectrum of the light source, such as sweeping a distinct spectral peak of light signal 104 . This shortens the effective coherence length of the light field as observed by the user, i.e., eye 120, so that interference patterns, like Newton rings, are not formed in the image observed by the user, i.e., eye 120. That is to say, spectral shaping performed within the persistence time of vision of the human eye, such as for example sweeping the central wavelength, can be used to decrease the coherence length of the light-source-and-eye -system and thus to decrease the visibility of (unwanted) interference patterns.

In some embodiments of the present invention, light signal 104 may be a laser signal. Lasers may be used to provide three discrete wavelengths, such as red, green and blue, and to enable easier implementation of working gratings. Lasers also enable higher operating efficiency and smaller form factors, which is particularly important in case of HMDs.

One challenge related to the use of lasers is unwanted interference, such as Newton rings, which should be minimized. According to some embodiments of the present invention, unwanted interference may be minimized by making a laser signal less coherent at a detector. A human eye may be considered as the detector and characteristics of the human eye may be taken into account to make the laser less coherent at the detector. For instance, if the averaging/integration time of the human eye is 20 milliseconds (50 Hz) and the distinct spectral characteristic of light signal 104 is swept over 2 nanometres during a time period of 20 milliseconds, i.e., during a period of time which corresponds to a persistence time of vision of the human eye, light signal 104 may be observed as incoherent by eye 120. This suppresses unwanted interference. Observed in slow motion, each freeze-frame may display interference, but observed at normal rate the human eye averages the distinct interference patterns, whereby the visibility of interference effects is much reduced.

In case of a laser, the spectrum of the light signal may be shaped by adjusting the cavity of the laser. Adjusting the cavity may comprise changing at least one of: cavity length, mirror reflectivity, and optical properties of materials. In an embodiment, light source 140 may be for example an open cavity diode laser. In case of the open cavity diode, a length of the cavity, which defines the wavelength, may be adjusted. A distinct spectral characteristic of the light signal may be thus swept by adjusting the length of the cavity accordingly. Alternatively, or in addition, light source 140 may be electrical and controlled by changing the driving current. So one way to shape the spectrum of a laser, as perceived by the human eye, is to shift the peak wavelength thereof within the persistence time of vision of the human eye. Shifting of the peak wavelength can be realized for example, but not exclusively, by electronically modifying driving current of a diode laser or by electronically modifying the cavity length of an open cavity diode laser by applying piezo-electric transducers.

In general, any laser source 140 that enables shaping of the spectrum of the laser signal 104 may be used. For instance, sweeping of a distinct spectral characteristic of the laser signal 104, i.e., sweeping of the peak wavelength, may be used. The open cavity diode laser provides one such choice. By shifting the peak wavelength embodiments of the present invention therefore enable spectral shaping, which makes it possible to create a desired shape for the spectrum. Spectral shaping/modulation is the general goal, and laser sources, the previously mentioned open cavity diode and changing of the driving current are merely exemplary means for achieving this goal.

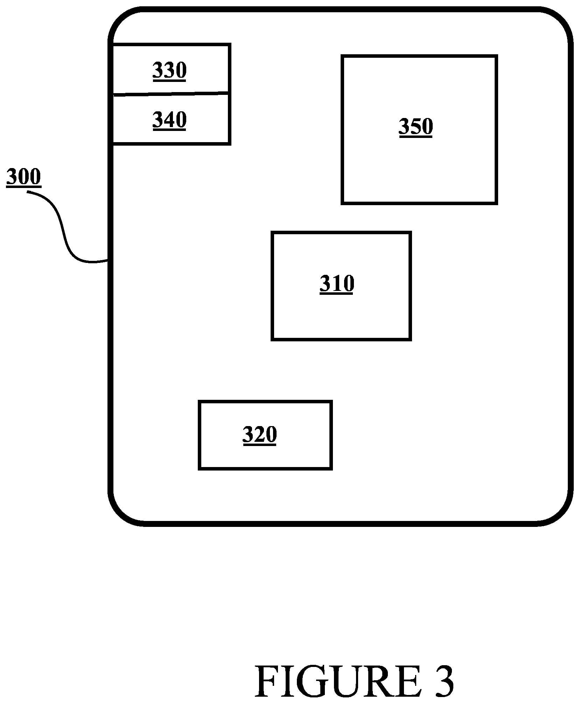

FIGURE 3 illustrates an example apparatus capable of supporting at least some embodiments of the present invention. Illustrated is apparatus 300, which may comprise, for example, a control mechanism for operating an optical waveguide arrangement, such as one illustrated in FIGURE 1 or FIGURE 2. Comprised in apparatus 300 is processor 310, which may comprise, for example, a single- or multi-core processor or microcontroller wherein a single-core processor comprises one processing core and a multi-core processor comprises more than one processing core. Processor 310 may comprise, in general, a control device. Processor 310 may comprise more than one processor. Processor 310 may be a control device. Processor 310 may comprise at least one Application-Specific Integrated Circuit, ASIC. Processor 310 may comprise at least one Field-Programmable Gate Array, FPGA. Processor 310 may be means for performing method steps in apparatus 300, such as transmitting and shifting. Processor 310 may be configured, at least in part by computer instructions, to perform actions. Processor 310 may be processor 150 in FIGURE 1.

Apparatus 300 may comprise memory 320. Memory 320 may comprise random-access memory and/or non-volatile memory. Memory 320 may comprise at least one RAM chip. Memory 320 may comprise solid-state, magnetic, optical and/or holographic memory, for example. Memory 320 may be at least in part accessible to processor 310. Memory 320 may be at least in part comprised in processor 310. Memory 320 may be means for storing information. Memory 320 may comprise computer instructions that processor 310 is configured to execute. When computer instructions configured to cause processor 310 to perform certain actions are stored in memory 320, and apparatus 300 overall is configured to run under the direction of processor 310 using computer instructions from memory 320, processor 310 and/or its at least one processing core may be considered to be configured to perform said certain actions. Memory 320 may be at least in part comprised in processor 310. Memory 320 may be at least in part external to apparatus 300 but accessible to apparatus 300. Memory 320 may store information defining segments of primary display 100, for example.

Apparatus 300 may comprise a transmitter 330. Apparatus 300 may comprise a receiver 340. Transmitter 330 and receiver 340 may be configured to transmit and receive, respectively, information in accordance with at least one cellular or non-cellular standard. Transmitter 330 may comprise more than one transmitter. Receiver 340 may comprise more than one receiver. Receiver 340 may be configured to receive an input image, and transmitter 330 may be configured to output control commands to direct mirror 130, where present, and light sources 140, for example, in accordance with the input image. Transmitter 430 and/or receiver 440 may be configured to operate in accordance with Wireless Local Area Network, WLAN, standards for example.

Apparatus 300 may comprise User Interface, UI, 350. UI 350 may comprise at least one of a display, a keyboard, a touchscreen, a vibrator arranged to signal to a user by causing apparatus 300 to vibrate, a speaker and a microphone. A user may be able to operate apparatus 300 via UI 350, for example to configure display parameters.

Processor 310 may be furnished with a transmitter arranged to output information from processor 310, via electrical leads internal to apparatus 300, to other devices comprised in apparatus 300. Such a transmitter may comprise a serial bus transmitter arranged to, for example, output information via at least one electrical lead to memory 320 for storage therein. Alternatively to a serial bus, the transmitter may comprise a parallel bus transmitter. Likewise processor 310 may comprise a receiver arranged to receive information in processor 310, via electrical leads internal to apparatus 300, from other devices comprised in apparatus 300. Such a receiver may comprise a serial bus receiver arranged to, for example, receive information via at least one electrical lead from receiver 340 for processing in processor 310. Alternatively to a serial bus, the receiver may comprise a parallel bus receiver.

Apparatus 300 may comprise further devices not illustrated in FIGURE 3. For instance, apparatus 300 may comprise a Near-Field Communication, NFC, transceiver. NFC transceiver may support at least one NFC technology, such as NFC, Bluetooth, Wibree or similar technologies. In some embodiments, apparatus 300 may lack at least one device described above. For example, some devices 300 may lack UI 350.

Processor 310, memory 320, transmitter 330, receiver 340 and/or UI 350 may be interconnected by electrical leads internal to apparatus 300 in a multitude of different ways. For example, each of the aforementioned devices may be separately connected to a master bus internal to apparatus 300, to allow for the devices to exchange information. However, as the skilled person will appreciate, this is only one example and depending on the embodiment various ways of interconnecting at least two of the aforementioned devices may be selected without departing from the scope of the present invention.

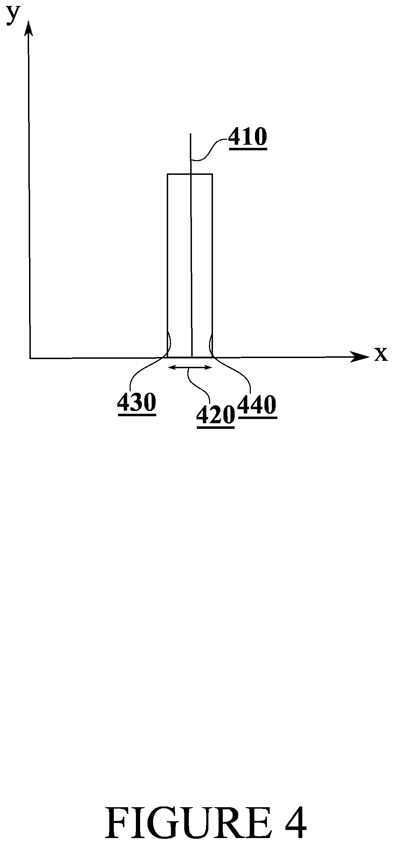

FIGURE 4 illustrates a first example of shaping of a spectrum of a light signal in accordance with at least some embodiments of the present invention. In FIGURE 4, a distinct spectral characteristic, e.g., a narrow distinct spectral peak 410 is swept over wavelength range 420 between a first wavelength 430 and a second wavelength 440, i.e., wavelength range 420 is the maximum sweep width. The x-axis represents wavelength and the y-axis represents amplitude. The narrow distinct spectral peak 410 may represent the light spectrum at the laser, which then determines the spectrum of the light signal along the whole optical path, such as the light signal 104 in FIGUREs 1 and 2. The peak in the spectrum 410 may be the light signal at a certain time instant. In FIGURE 4, the amplitude of the narrow distinct spectral peak 410 is kept constant while the position of the narrow distinct spectral peak 410 is swept between the first wavelength 430 and the second wavelength 440. In some embodiments, a spectral peak swept over wavelength range 420 may be a wider spectral distribution, i.e., it may comprise non-zero amplitude at multiple frequencies. The sweeping wavelength range 420 describes a range of locations of peak wavelength of the spectral characteristics. Parts of the spectrum may lie outside the sweeping wavelength range 420, especially in the case of wider spectral distributions. The spectral shape and the amplitude of the light source, including the peak, may be modulated during sweeping.

The distinct spectral characteristic of the light signal may be swept during a period of time, e.g., by at least one processor 150 of FIGURE 1, to achieve a smooth spectral profile. As a special case, the distinct spectral characteristic of the light signal may be changed multiple times during a period of time. The distinct spectral characteristic may for example be swept continuously or shifted multiple times to create a large number of peaks, so that the spectral profile becomes smooth. Intensity of the distinct spectral characteristic of the light signal may be adjusted during sweeping/shifting as well. Said period of time may correspond to a persistence time of vision of the human eye. The light signal may be thus observed as incoherent by the human eye during said period of time.

In some embodiments, the distinct spectral characteristic of the signal may be swept within a range of a few nanometres. For instance, the distinct spectral characteristic of the light signal may be swept by about 2 nanometres during said period of time, i.e., maximum shift of the sweeping wavelength range 420 of the distinct spectral characteristic of the light signal may be about 2 nanometres. For instance, the wavelength of the signal may be swept around a central wavelength by +/- 1 nanometre. In some embodiments, the wavelength of the signal may be swept around a central wavelength by +/- 5 nanometres. In some embodiments, a wider sweeping wavelength range is used in connection with amplitude modulation such as the amplitude decreasing towards the end points of the sweeping wavelength range.

The distinct spectral characteristic of the light signal may be swept/shifted between first wavelength 430 and second wavelength 440 during said period of time. That is to say, the distinct spectral characteristic of the light signal may be shifted more than once, i.e., multiple times, during said period of time. For instance, the distinct spectral characteristic may be shifted, possibly gradually, from first wavelength 430 to second wavelength 440 during said period of time. Alternatively, the distinct spectral characteristic may be shifted, possibly gradually, from first wavelength 430 to second wavelength 440 and then from second wavelength 440 back to first wavelength 430. In some embodiments, the distinct spectral characteristic may be swept from the central wavelength towards the end points 430 and 440 of the sweeping wavelength range 420 in arbitrary order.

In some embodiments, the distinct spectral characteristic may be swept/shifted uniformly so that a step size of each shift is the same, to enable simple implementation. Alternatively, the distinct spectral characteristic may be swept/shifted non-uniformly so that a step size of each shift is not the same, to cope with certain hardware restrictions.

The distinct spectral characteristic of the light signal is swept/shifted continuously, i.e., non-stop, during said period of time, to make the light signal less coherent and enable incoherent detection by a human eye. More specifically, in some embodiments, the distinct spectral characteristic of the light signal may be swept/shifted continuously in a discrete manner. That is to say, the distinct spectral characteristic of the light signal may be shifted multiple times during said period of time, but in a continuous manner. A spectral shape of the distinct spectral characteristic may also change during said period of time, i.e., the spectral shape of the distinct spectral characteristic may change in connection with the wavelength change. In some embodiments, the sweeping wavelength range is swept multiple times during said period of time.

In some embodiments, the intensity and/or the spectral shape of the distinct spectral characteristic of the light signal may be changed during sweeping/shifting as well, e.g., by at least one processor 150 of FIGURE 1. A more general modulation of the spectral shape is also possible, and can for example be the result of changes to the intensity of the distinct spectral characteristic of the light signal and/or due to changing the light source.

In some embodiments, the light source may be a laser source and the light signal may be a laser signal. For instance, the laser source may be an open cavity diode laser. Lasers may be used for example to enable easier implementation of working gratings, e.g., for HMDs.

The persistence time of vision of the human eye may depend on the individual person and thus, the persistence time of vision may be different for different persons. In some embodiments, it may be assumed that the persistence time of vision of a human eye is 20 milliseconds and thus, said period of time may be 20 milliseconds as well. Hence, the light signal may be observed as incoherent by the human eye during said period of time. In some example embodiments, said period of time is 5 - 200 milliseconds.

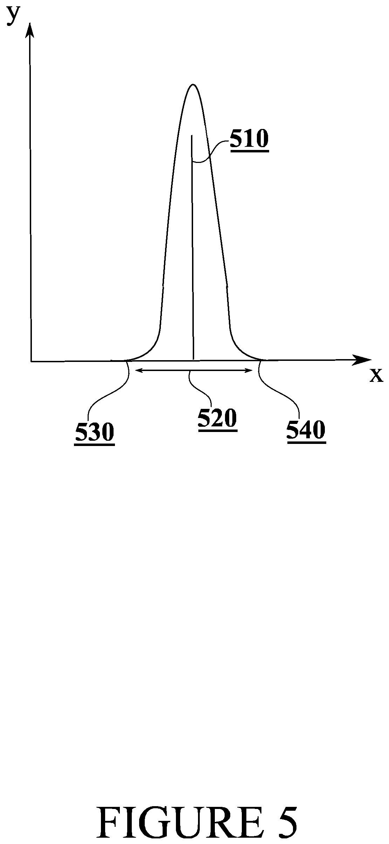

FIGURE 5 illustrates a second example of shaping a spectrum of a light signal in accordance with at least some embodiments of the present invention. Also in FIGURE 5, a distinct spectral characteristic, e.g., a narrow distinct spectral peak 510 is swept over sweeping wavelength range 520 between a first wavelength 530 and a second wavelength 540, i.e., wavelength range 520 is the maximum sweep width. The x-axis represents wavelength and the y-axis represents amplitude. Again, the narrow distinct spectral peak 510 may represent the light spectrum at the laser, which then determines the spectrum of the light signal along the whole optical path, such as the light signal 104 in FIGUREs 1 and 2.

The distinct spectral characteristic of the light signal may be swept/shifted similarly as in the embodiment of FIGURE 4 but in case of spectral shaping, i.e., shaping of a spectrum, shown in FIGURE 5, the amplitude of the light signal may be changed as a function of the wavelength. Thus, lower amplitudes may be used for example closer to the end points of the wavelength range 520, i.e., closer to first wavelength 530 and second wavelength 540. In FIGURE 5, the highest amplitude is shown in the middle of the sweeping wavelength range 520. In some embodiments, the highest amplitude may be located in other parts of the sweeping wavelength range 520. If there are sharp edges in the spectrum, such edges may behave like peaks. Hence, the amplitude of the light signal may be changed so that the amplitude approaches zero with wavelengths that are closer to the end points of the wavelength range 520, i.e., when approaching the first wavelength 530 and the second wavelength 540. However, in some embodiments, sweeping may follow a sinusoidal pattern, which stays longer at the end points of the sweeping wavelength range. Even a uniform distribution may therefore require active controlling of the intensity during sweeping. In general, benefit of spectral shaping is that coherence properties may be shaped from the point of view of the detector, i.e., the human eye. In some embodiments, a spectral peak swept over wavelength range 520 may be a wider spectral distribution.

In general, a spectrum of the light signal may be shaped during a period of time, said period of time corresponding to a persistence time of vision of the human eye. Said shaping of the spectrum may comprise sweeping a distinct spectral characteristic of the light signal during said period of time, changing an amplitude of the light signal as a function of a wavelength such that lower amplitudes are used at end points of the sweeping wavelength range compared to a maximum amplitude at the sweeping wavelength range, changing a spectral shape of the light signal during said period of time to achieve a smooth spectral profile and/or changing an intensity of the light signal during said period of time to achieve a smooth spectral profile. In some embodiments, a wider spectral distribution may be swept instead of a peak of distinct spectral characteristics.

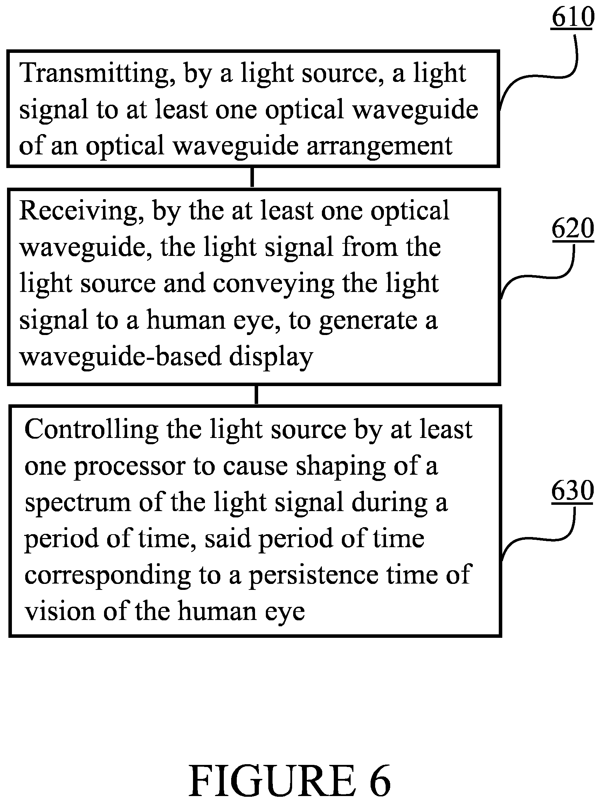

FIGURE 6 is a flow graph of a method in accordance with at least some embodiments of the present invention. The phases of the illustrated method may be performed in an optical waveguide arrangement or by apparatus 300 of FIGURE 3, or in a control mechanism configured to control the functioning thereof, when installed therein.

The method may comprise, at step 610, transmitting by a light source a light signal to at least one optical waveguide of the optical waveguide arrangement. Moreover, the method may comprise, at step 620, receiving by the at least one optical waveguide the light signal from the light source and conveying the light signal to a human eye, to generate a waveguide-based display. Finally, the method may comprise, at step 630, controlling the light source by at least one processor to cause shaping of a spectrum of the light signal during a period of time, said period of time corresponding to a persistence time of vision of the human eye.

It is to be understood that the embodiments of the invention disclosed are not limited to the particular structures, process steps, or materials disclosed herein, but are extended to equivalents thereof as would be recognized by those ordinarily skilled in the relevant arts. It should also be understood that terminology employed herein is used for the purpose of describing particular embodiments only and is not intended to be limiting.

Reference throughout this specification to one embodiment or an embodiment means that a particular feature, structure, or characteristic described in connection with the embodiment is included in at least one embodiment of the present invention. Thus, appearances of the phrases "in one embodiment" or "in an embodiment" in various places throughout this specification are not necessarily all referring to the same embodiment. Where reference is made to a numerical value using a term such as, for example, about or substantially, the exact numerical value is also disclosed.

As used herein, a plurality of items, structural elements, compositional elements, and/or materials may be presented in a common list for convenience. However, these lists should be construed as though each member of the list is individually identified as a separate and unique member. Thus, no individual member of such list should be construed as a de facto equivalent of any other member of the same list solely based on their presentation in a common group without indications to the contrary. In addition, various embodiments and example of the present invention may be referred to herein along with alternatives for the various components thereof. It is understood that such embodiments, examples, and alternatives are not to be construed as de facto equivalents of one another, but are to be considered as separate and autonomous representations of the present invention.

In an exemplary embodiment, an apparatus, such as, for example, apparatus 300 in FIGURE 3, may comprise means for carrying out the embodiments described above and any combination thereof.

In an exemplary embodiment, a computer program may be configured to cause a method in accordance with the embodiments described above and any combination thereof. In an exemplary embodiment, a computer program product, embodied on a non-transitory computer readable medium, may be configured to control a processor to perform a process comprising the embodiments described above and any combination thereof.

In an exemplary embodiment, an apparatus, such as, for example, apparatus 300 in FIGURE 3, may comprise at least one processor, and at least one memory including computer program code, wherein the at least one memory and the computer program code are configured to, with the at least one processor, cause the apparatus at least to perform the embodiments described above and any combination thereof.

Furthermore, the described features, structures, or characteristics may be combined in any suitable manner in one or more embodiments. In the preceding description, numerous specific details are provided, such as examples of lengths, widths, shapes, etc., to provide a thorough understanding of embodiments of the invention. One skilled in the relevant art will recognize, however, that the invention can be practiced without one or more of the specific details, or with other methods, components, materials, etc. In other instances, well-known structures, materials, or operations are not shown or described in detail to avoid obscuring aspects of the invention.

While the forgoing examples are illustrative of the principles of the present invention in one or more particular applications, it will be apparent to those of ordinary skill in the art that numerous modifications in form, usage and details of implementation can be made without the exercise of inventive faculty, and without departing from the principles and concepts of the invention. Accordingly, it is not intended that the invention be limited, except as by the claims set forth below.

The verbs "to comprise" and "to include" are used in this document as open limitations that neither exclude nor require the existence of also un-recited features. The features recited in depending claims are mutually freely combinable unless otherwise explicitly stated. Furthermore, it is to be understood that the use of "a" or "an", that is, a singular form, throughout this document does not exclude a plurality.

### INDUSTRIAL APPLICABILITY

At least some embodiments of the present invention find industrial application in HMDs and HUDs.

### ACRONYMS LIST

- ASIC: Application-Specific Integrated Circuit
- FPGA: Field-Programmable Gate Array
- HMD: Heam-Mounted Display
- HUD: Head-Up Display
- LCOS: Liquid Crystal on Silicon
- LED: Light-Emitting Diode
- NFC: Near-Field Communication
- MEMS: Microelectromechanical System
- ROI: Region of Interest
- UI: User Interface
- WLAN: Wireless Local Area Network

### REFERENCE SIGNS LIST

| | |
|---|---|
| 100 | Light field |
| 102 | Optical guides |
| 103 | In-coupling structure |
| 104 | Light |
| 110 | Waveguide |
| 111 | Interface, towards an eye |
| 112 | Elements |
| 113 | Opposite interface, towards the world |
| 114 | First light signal |
| 115 | Second light signal |
| 116 | Reflected light signal |
| 120 | Eye(s) |
| 130 | Mirror |
| 140 | Light sources |
| 150 | Processor |
| 300 - 350 | Structure of the apparatus of FIGURE 3 |
| 410, 510 | Peak in spectrum |
| 420, 520 | Sweeping wavelength range |
| 430, 530 | First wavelength |
| 440, 540 | Second wavelength |
| 610 - 630 | Phases of the method of FIGURE 6 |

## Claims

1. An optical waveguide arrangement comprising:
- a light source arranged to transmit a light signal to at least one optical waveguide of the optical waveguide arrangement;
- the at least one optical waveguide, wherein the at least one optical waveguide is arranged to receive the light signal from the light source and to convey the light signal to a human eye, to generate a waveguide-based display; and
- at least one processor configured to control the light source, wherein the at least one processor is configured to cause shaping of a spectrum of the light signal during a period of time, said period of time corresponding to a persistence time of vision of the human eye, wherein the at least one processor is further configured to cause shaping of a spectrum of the light signal between a first wavelength and a second wavelength during said period of time and said shaping of the spectrum comprises sweeping a distinct spectral characteristic of the light signal during said period of time; and wherein the distinct spectral characteristic of the light signal is swept continuously during said period of time.

2. An optical waveguide arrangement according to claim 1, wherein the distinct spectral characteristic of the light signal is swept uniformly during said period of time.

3. An optical waveguide arrangement according to any of the preceding claims, wherein the distinct spectral characteristic of the light signal is swept by about 2 nanometres during said period of time.

4. An optical waveguide arrangement according to any of the preceding claims, wherein said shaping of the spectrum comprises changing an amplitude of the light signal as a function of a wavelength such that lower amplitudes are used at end points of a sweeping wavelength range compared to a highest amplitude in the sweeping wavelength range.

5. An optical waveguide arrangement according to any of the preceding claims, wherein said shaping of the spectrum comprises changing a spectral shape of the light signal during said period of time to achieve a smooth spectral profile.

6. An optical waveguide arrangement according to any of the preceding claims, wherein said shaping of the spectrum comprises changing an intensity of the light signal during said period of time to achieve a smooth spectral profile.

7. An optical waveguide arrangement according to any of the preceding claims, wherein the light source is a laser source and the light signal is a laser signal.

8. An optical waveguide arrangement according to any of the preceding claims, wherein said period of time is about tens of milliseconds corresponding to the persistence time of vision of the human eye, preferably 5 - 200 milliseconds, like 20 milliseconds.

9. An optical waveguide arrangement according to any of the preceding claims, wherein the at least one processor is configured to cause said shaping of the spectrum of the light signal during said period of time to shorten an effective coherence length of the light signal.

10. A head-mounted display or a head-up display comprising an optical waveguide arrangement according to any of the preceding claims.

11. A method for an optical waveguide arrangement, comprising
- transmitting by a light source a light signal to at least one optical waveguide of the optical waveguide arrangement;
- receiving by the at least one optical waveguide the light signal from the light source and conveying the light signal to a human eye, to generate a waveguide-based display; and
- controlling the light source by at least one processor to cause shaping of a spectrum of the light signal during a period of time, said period of time corresponding to a persistence time of vision of the human eye; and
- causing, by the at least one processor, shaping of a spectrum of the light signal between a first wavelength and a second wavelength during said period of time, wherein said shaping of the spectrum comprises sweeping a distinct spectral characteristic of the light signal during said period of time; and wherein sweeping the distinct spectral characteristic of the light signal happens continuously during said period of time.

12. A computer program comprising instructions which, when the program is executed by an apparatus, cause the apparatus to perform a method according to claim 11.

## Patentansprüche

1. Optische Wellenleiteranordnung, umfassend:
- eine Lichtquelle, die dazu angeordnet ist, ein Lichtsignal an zumindest einen optischen Wellenleiter der optischen Wellenleiteranordnung zu übertragen;
- den zumindest einen optischen Wellenleiter, wobei der zumindest eine optische Wellenleiter dazu angeordnet ist, das Lichtsignal von der Lichtquelle zu empfangen und das Lichtsignal zu einem menschlichen Auge zu befördern, um eine wellenleiterbasierte Anzeige zu erzeugen; und
- zumindest einen Prozessor, der dazu konfiguriert ist, die Lichtquelle zu steuern, wobei der zumindest eine Prozessor dazu konfiguriert ist, Formung eines Spektrums des Lichtsignals während eines Zeitraums zu bewirken, wobei der Zeitraum einer Persistenzzeit des Sehens des menschlichen Auges entspricht, wobei der zumindest eine Prozessor ferner dazu konfiguriert ist, Formung eines Spektrums des Lichtsignals zwischen einer ersten Wellenlänge und einer zweiten Wellenlänge während des Zeitraums zu bewirken, und die Formung des Spektrums Überstreichen einer bestimmten Spektralcharakteristik des Lichtsignals während des Zeitraums umfasst; und wobei die bestimmte Spektralcharakteristik des Lichtsignals während des Zeitraums kontinuierlich überstrichen wird.

2. Optische Wellenleiteranordnung nach Anspruch 1, wobei die bestimmte Spektralcharakteristik des Lichtsignals während des Zeitraums gleichmäßig überstrichen wird.

3. Optische Wellenleiteranordnung nach einem der vorhergehenden Ansprüche, wobei die bestimmte Spektralcharakteristik des Lichtsignals während des Zeitraums um etwa 2 Nanometer überstrichen wird.

4. Optische Wellenleiteranordnung nach einem der vorhergehenden Ansprüche, wobei die Formung des Spektrums Ändern einer Amplitude des Lichtsignals als Funktion einer Wellenlänge umfasst, sodass niedrigere Amplituden an Endpunkten eines überstreichenden Wellenlängenbereichs verglichen mit einer höchsten Amplitude in dem überstreichenden Wellenlängenbereich verwendet werden.

5. Optische Wellenleiteranordnung nach einem der vorhergehenden Ansprüche, wobei die Formung des Spektrums Ändern einer Spektralform des Lichtsignals während des Zeitraums umfasst, um ein glattes Spektralprofil zu erreichen.

6. Optische Wellenleiteranordnung nach einem der vorhergehenden Ansprüche, wobei die Formung des Spektrums Ändern einer Intensität des Lichtsignals während des Zeitraums umfasst, um ein glattes Spektralprofil zu erreichen.

7. Optische Wellenleiteranordnung nach einem der vorhergehenden Ansprüche, wobei die Lichtquelle eine Laserquelle ist und das Lichtsignal ein Lasersignal ist.

8. Optische Wellenleiteranordnung nach einem der vorhergehenden Ansprüche, wobei der Zeitraum etwa zehn Millisekunden entsprechend der Persistenzzeit des Sehens des menschlichen Auges ist, bevorzugt 5-200 Millisekunden, wie 20 Millisekunden.

9. Optische Wellenleiteranordnung nach einem der vorhergehenden Ansprüche, wobei der zumindest eine Prozessor dazu konfiguriert ist, die Formung des Spektrums des Lichtsignals während des Zeitraums zu bewirken, um eine effektive Kohärenzlänge des Lichtsignals zu verkürzen.

10. Kopfmontierte Anzeige oder Head-up-Anzeige, umfassend eine optische Wellenleiteranordnung nach einem der vorhergehenden Ansprüche.

11. Verfahren für eine optische Wellenleiteranordnung, umfassend
- Übertragen, durch eine Lichtquelle, eines Lichtsignals an zumindest einen optischen Wellenleiter der optischen Wellenleiteranordnung;
- Empfangen, durch den zumindest einen optischen Wellenleiter, des Lichtsignals von der Lichtquelle und Befördern des Lichtsignals zu einem menschlichen Auge, um eine wellenleiterbasierte Anzeige zu erzeugen; und
- Steuern der Lichtquelle durch zumindest einen Prozessor, um Formung eines Spektrums des Lichtsignals während eines Zeitraums zu bewirken, wobei der Zeitraum einer Persistenzzeit des Sehens des menschlichen Auges entspricht; und
- Bewirken, durch den zumindest einen Prozessor, von Formung eines Spektrums des Lichtsignals zwischen einer ersten Wellenlänge und einer zweiten Wellenlänge während des Zeitraums, wobei die Formung des Spektrums Überstreichen einer bestimmten Spektralcharakteristik des Lichtsignals während des Zeitraums umfasst; und wobei das Überstreichen der bestimmten Spektralcharakteristik des Lichtsignals während des Zeitraums kontinuierlich erfolgt.

12. Computerprogramm, umfassend Anweisungen, die, wenn das Programm durch eine Vorrichtung ausgeführt wird, bewirken, dass die Vorrichtung ein Verfahren nach Anspruch 11 durchführt.

## Revendications

1. Agencement de guide d'ondes optique comprenant :
- une source de lumière agencée pour transmettre un signal lumineux à au moins un guide d'ondes optique de l'agencement de guide d'ondes optique ;
- l'au moins un guide d'ondes optique, ledit au moins un guide d'ondes optique étant agencé pour recevoir le signal lumineux en provenance de la source de lumière et pour transporter le signal lumineux à un œil humain, afin de générer un affichage basé sur un guide d'ondes ; et
- au moins un processeur configuré pour commander la source de lumière, ledit au moins un processeur étant configuré pour entraîner la mise en forme d'un spectre du signal lumineux durant une période de temps, ladite période de temps correspondant à un temps de persistance de la vision de l'œil humain, ledit au moins un processeur étant en outre configuré pour entraîner la mise en forme d'un spectre du signal lumineux entre une première longueur d'onde et une seconde longueur d'onde durant ladite période de temps et ladite mise en forme du spectre comprenant le balayage d'une caractéristique spectrale distincte du signal lumineux durant ladite période de temps ; et ladite caractéristique spectrale distincte du signal lumineux étant balayée en continu durant ladite période de temps.

2. Agencement de guide d'ondes optique selon la revendication 1, ladite caractéristique spectrale distincte du signal lumineux étant balayée uniformément durant ladite période de temps.

3. Agencement de guide d'ondes optique selon l'une quelconque des revendications précédentes, ladite caractéristique spectrale distincte du signal lumineux étant balayée d'environ 2 nanomètres durant ladite période de temps.

4. Ensemble de guides d'ondes optique selon l'une quelconque des revendications précédentes, ladite mise en forme du spectre comprenant la modification d'une amplitude du signal lumineux en fonction d'une longueur d'onde de sorte que des amplitudes plus faibles soient utilisées au niveau des points d'extrémité d'une plage de longueurs d'onde de balayage par rapport à l'amplitude la plus élevée dans la plage de longueurs d'onde de balayage.

5. Agencement de guide d'ondes optique selon l'une quelconque des revendications précédentes, ladite mise en forme du spectre comprenant la modification d'une forme spectrale du signal lumineux durant ladite période de temps pour réaliser un profil spectral lisse.

6. Agencement de guide d'ondes optique selon l'une quelconque des revendications précédentes, ladite mise en forme du spectre comprenant la modification d'une intensité du signal lumineux durant ladite période de temps pour réaliser un profil spectral lisse.

7. Agencement de guide d'ondes optique selon l'une quelconque des revendications précédentes, ladite source de lumière étant une source laser et ledit signal lumineux étant un signal laser.

8. Agencement de guide d'ondes optique selon l'une quelconque des revendications précédentes, ladite période de temps étant environ des dizaines de millisecondes correspondant au temps de persistance de la vision de l'œil humain, de préférence de 5 à 200 millisecondes, comme 20 millisecondes.

9. Agencement de guide d'ondes optique selon l'une quelconque des revendications précédentes, ledit au moins un processeur étant configuré pour entraîner ladite mise en forme du spectre du signal lumineux durant ladite période de temps pour raccourcir une longueur de cohérence effective du signal lumineux.

10. Dispositif d'affichage monté sur casque ou dispositif d'affichage tête haute comprenant un agencement de guide d'ondes optique selon l'une quelconque des revendications précédentes.

11. Procédé permettant un agencement de guide d'ondes optique, comprenant
- la transmission par une source de lumière d'un signal lumineux à au moins un guide d'ondes optique de l'agencement de guide d'ondes optique ;
- la réception par l'au moins un guide d'ondes optique du signal lumineux en provenance de la source de lumière et le transport du signal lumineux à un œil humain, afin de générer un affichage basé sur un guide d'ondes ; et
- la commande de la source de lumière par au moins un processeur pour entraîner la mise en forme d'un spectre du signal lumineux durant une période de temps, ladite période de temps correspondant à un temps de persistance de la vision de l'œil humain ; et
- l'entraînement, par ledit au moins un processeur, de la mise en forme d'un spectre du signal lumineux entre une première longueur d'onde et une seconde longueur d'onde durant ladite période de temps, ladite mise en forme du spectre comprenant le balayage d'une caractéristique spectrale distincte du signal lumineux durant ladite période de temps ; et ledit balayage de la caractéristique spectrale distincte du signal lumineux se produisant en continu durant ladite période de temps.

12. Programme informatique comprenant des instructions qui, lorsque le programme est exécuté par un appareil, amènent l'appareil à réaliser un procédé selon la revendication 11.
